**Europäisches Patentamt**

**European Patent Office**

**Office européen des brevets**

(11) Numéro de publication: **0 018 250**
**A1**

## DEMANDE DE BREVET EUROPEEN

(21) Numéro de dépôt: **80400402.6**

(22) Date de dépôt: **26.03.80**

(51) Int. Cl.³: **H 01 L 23/06,** H 01 L 23/26,
H 05 K 5/06, H 03 H 9/10

(30) Priorité: **18.04.79 FR 7909725**

(43) Date de publication de la demande: **29.10.80**
**Bulletin 80/22**

(84) Etats contractants désignés: **DE GB IT NL**

(71) Demandeur: **COMPAGNIE D'ELECTRONIQUE ET DE PIEZOELECTRICITE - C.E.P.E., 101, rue du Président Roosevelt, F-78500 Sartrouville (FR)**

(72) Inventeur: **Erkens, Andre, "THOMSON-CSF"**
**SCPI 173, Bld Haussmann, F-75360 Paris Cedex 08 (FR)**

(74) Mandataire: **Eisenbeth, Jacques Pierre et al, "THOMSON-CSF" - SCPI 173, bld Haussmann, F-75360 Paris Cedex 08 (FR)**

(54) Boîtier d'encapsulation pour composant électronique, et composant comportant un tel boîtier.

(57) L'invention concerne les boîtiers étanches pour composants électroniques.

Un tel boîtier est constitué d'une embase (1) et d'un capot (2) métalliques, dont la réunion réalise un boîtier étanche, après fermeture du queusot (11). Cependant, les parois dégagent ultérieurement des impuretés qui souillent l'atmosphère interne, et l'invention consiste à revêtir ces parois d'une couche d'émail (12), dont la surface ne peut dégager aucune impureté néfaste.

Les applications sont notamment du domaine de l'encapsulation des dispositifs semi-conducteurs et des résonateurs piézo-électriques.

1

# BOITIER D'ENCAPSULATION POUR COMPOSANT ELECTRONIQUE, ET COMPOSANT COMPORTANT UN TEL BOITIER

La présente invention se rapporte au domaine connu dans la technique sous le nom d'encapsulation. Cette notion concerne la protection, contre les causes de dégradation diverses dues à l'environnement, de dispositifs tels que, par exemple, des circuits intégrés à l'état solide, des relais électromécaniques, des résonateurs piézoélectriques.

Deux causes principales de dégradation sont constatées en pratique, l'une liée à des phénomènes de corrosion chimique-oxydation par l'oxygène de l'air, atmosphères acides ou basiques, air salin - l'autre à la vapeur d'eau.

Dans tous les cas, la solution du problème est obtenue en enfermant le dispositif à protéger dans une enceinte étanche, qui est habituellement désignée sous le nom de boîtier.

De plus, le choix de l'atmosphère gazeuse intérieure étant librement déterminable, on peut alors effectuer un remplissage de gaz chimiquement neutre tel que l'azote, l'hélium, ou un mélange hélium-néon. Dans certaines applications, telles que les tubes électroniques par exemple, on peut même créer un vide élevé, de l'ordre de $10^{-6}$ mm de mercure.

Pour la réalisation pratique des boîtiers, il a été fait jusqu'à maintenant appel soit à un métal, soit à un verre, un boîtier étant, dans l'un ou l'autre cas, constitué par la réunion et la soudure d'un capot sur une embase, après avoir fixé le dispositif à encapsuler sur celle-ci.

2

Cependant, il a été constaté que, au cours de l'utilisation du dispositif ainsi encapsulé, la composition de l'atmosphère intérieure évolue avec le temps, des impuretés telles que des traces de l'air ambiant lors de la fermeture, et de vapeur d'eau, se dégageant progressivement. Ces impuretés avaient été retenues sur la face interne des boîtiers par les phenomènes de l'adsorption et de l'absorption, dans des proportions beaucoup plus importantes pour les surfaces métalliques que pour les surfaces de verre par exemple.

En pratique cependant, malgré les avantages présentés par les boîtiers de verre, on met le plus souvent en oeuvre dans l'industrie des boîtiers de métal de bonne soudabilité, cuivre ou acier, recouvert: de couches de métaux peu oxydables, tels que le nickel, l'or ou une succession des deux, ou le maillechort, alliage de cuivre, de nickel et de zinc, où l'on a maintenu une faible teneur de ce dernier métal.

L'adoption d'un métal permet en effet, industriellement, un prix de revient réduit, une fabrication aisée automatisable, et avec des installations peu coûteuses.

Le boîtier obtenu est d'autre part robuste et résiste bien aux efforts mécaniques accidentels.

L'adoption du verre pour un boîtier présente les inconvénients corrolaires, à savoir le coût plus élevé du boîtier, des installations de soudure ou "fermeture" complexes, et, bien entendu, la fragilité du boîtier obtenu.

La comparaison des deux types de matériaux est résummée dans le tableau ci-après.

3

| | Boîtiers métalliques | Boîtiers en verre |
|---|---|---|
| Avantages | Coût peu élevé. Rapidité de mise en oeuvre. Possibilité d'automatisation de la fermeture. Robustesse. | Très bonne conservation des qualités initiales du dispositif encapsulé. Qualité élevée. |
| Inconvénients | Altération dans le temps des caractéristiques des dispositifs encapsulés dues à des phénomènes de migration à partir de la surface métallique du boîtier. | Coût plus élevé. Installation de fermetures complexes. Robustesse mécanique limitée. |

Cependant, malgré ses inconvénients, le verre est préféré dans les cas où une protection durable de haute qualité est indispensable ; ses avantages, qui doivent être considérés comme primordiaux, ont leur origine dans le fait qu'une surface vitreuse peut être nettoyée et dépolluée beaucoup plus efficacement qu'une surface métallique. Par conséquent, les transferts de gaz et/ou de vapeurs diverses du boîtier vers le dispositif encapsulé, qui sont à l'origine des altérations constatées en cours de la vie du produit,

0018250

4

sont réduits à une valeur minimale, et restent pratiquement imperceptibles.

La présente invention concerne un boîtier d'encapsulation comportant les avantages d'un boîtier en verre, sans en présenter les inconvénients.

Dans son principe, elle réalise une combinaison entre les deux types de protection, en faisant appel à un boîtier métallique qui procure les avantages de résistance mécanique, et de bas prix de revient des soudures à la fermeture, et en revêtant celui-ci, sur la face interne de ses parois, d'une couche d'un produit vitreux tel qu'un verre ou un émail vitrifié, procurant les avantages de bonne conservation des caractéristiques initiales des produits encapsulés, avec une qualité élevée possible de ces caractéristiques.

Plus précisément, l'invention concerne un boîtier pour encapsulation pour composant électronique, constitué, en deux parties, d'une embase et d'un capot, l'un et l'autre étant munis de surfaces marginales, dont la mise en contact réalise la fermeture étanche du boîtier, et l'une des deux parties étant munie d'un queusot en forme de tube permettant de déterminer les caractéristiques de l'atmosphère intérieure, et de connexions conductrices de traversée fixées par des anneaux isolants, caractérisé en ce que les surfaces internes des deux parties du boîtier sont recouvertes d'une couche d'émail appartenant au groupe physico-chimique des verres.

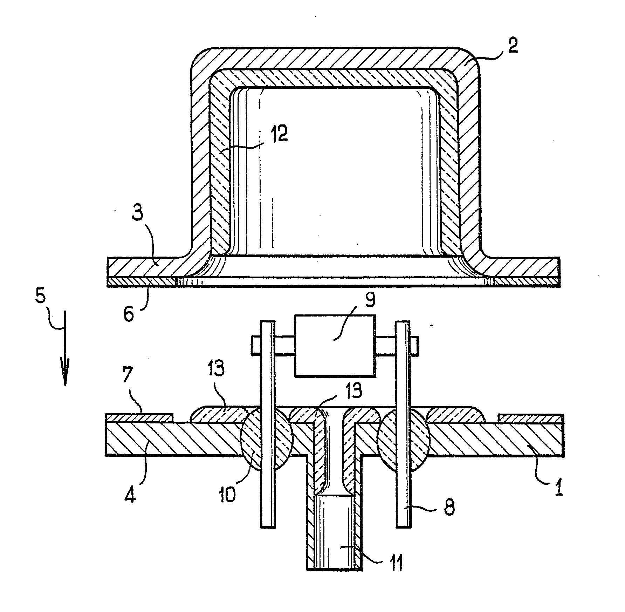

La présente invention sera mieux comprise à l'aide de la description ci-après, en s'appuyant sur la figure jointe, qui représente, suivant une vue en coupe, un boîtier d'encapsulation selon l'invention.

5

Le boîtier se compose d'une embase 1 et d'un capot 2, l'un et l'autre présentant deux surfaces 3 et 4 marginales destinées à la soudure ou "fermeture", effectuée suivant la direction 5, par fermeture électrique ou fermeture à froid.

En vue de faciliter cette opération, une couche d'un matériau à haute soudabilité, tel que l'indium, peut être déposée sur ces surfaces, en 6 et 7.

Le capot et l'embase sont en métal, tel que l'acier par exemple, et l'embase comporte des connexions électriquement conductrices telles que 8, la traversant pour raccordement avec l'extérieur du dispositif à protéger 9. Ces connexions sont isolées de l'embase par des anneaux de verre 10 en forme de "perles". L'embase porte enfin un tube 11, habituellement désigné sous le nom de queusot, par lequel l'atmosphère intérieure, - remplissage gazeux ou vide élevé - peut être réalisée. Il est à noter que, dans certains modes de réalisation, c'est le capot qui porte le queusot.

Selon l'invention, le capot et le boîtier sont intérieurement recouverts de couches 12 et 13 d'un matériau vitreux, tel qu'un émail vitrifié à haute température.

Un émail constitué de boro-silicate, et vitrifié par passage dans un four à 850° peut par exemple être utilisé ; une gamme de températures comprises entre 800° et 900° peut convenir.

Cet émail peut faire partie de la famille physico-chimique des verres, et la couche d'émail 13 déposée sur l'embase peut se combineravec les perles de verre 10, assurant l'isolement des connexions conductrices de traversée de l'embase.

6

Le queusot peut, partiellement, être également revêtu d'une couche interne de matériau vitreux.

Les avantages procurés par la combinaison selon l'invention, sur l'évolution de l'atmosphère intérieure, sont sensiblement les mêmes que ceux apportés par un boîtier entièrement en verre.

A titre d'exemple, l'évolution constatée est alors ralentie, dans une proportion de l'ordre de 10 fois, par rapport au cas du boîtier à surface interne métallique.

Il est à remarquer que, bien que la description précédente ait été faite dans le cas d'un revêtement intérieur de type émail minéral vitrifié à haute température, la mise en oeuvre d'un matériau organique à haute stabilité chimique, et ne présentant pas de phénomène de dégazage notable, tel que ceux de la famille des cyano-acrylates, est comprise dans le domaine de l'invention.

7

## REVENDICATIONS

1. Boîtier d'encapsulation pour composant électronique, constitué, en deux parties, d'une embase (1) et d'un capot (2), l'un et l'autre étant munis de surface marginales (3) et (4), dont la mise en contact réalise la fermeture étanche du boîtier, et l'une des deux parties étant munie d'un queusot en forme de tube (11) permettant de déterminer les caractéristiques de l'atmosphère intérieure, et de connexions conductrices de traversée (8) fixées par des anneaux isolants (10), les surfaces internes des deux parties du boîtier étant recouvertes d'une couche d'un matériau (12), (13) appartenant au groupe physico-chimique des verres, boîtier caractérisé en ce que ce matériau est un émail constitué d'un borosilicate fondu à une température comprise entre 800° et 900°C.

2. Boîtier d'encapsulation suivant la revendication 1, caractérisé en ce que la couche de matériau et les anneaux isolants supportés par l'embase appartiennent au même groupe physico-chimique, réalisant une couche continue.

3. Boîtier d'encapsulation suivant l'une des revendications précédentes, caractérisé en ce que ledit matériau recouvre partiellement la surface interne du queusot.

4. Résonateur piézo-électrique, caractérisé en ce qu'il comporte un boîtier d'encapsulation selon l'une des revendications précédentes.

**Office européen
des brevets**

**RAPPORT DE RECHERCHE EUROPEENNE**

0018250

Numéro de la demande

EP 80 40 0402

## DOCUMENTS CONSIDERES COMME PERTINENTS

| Catégorie | Citation du document avec indication, en cas de besoin, des parties pertinentes | Revendication concernée |
|-----------|-----------------------------------------------------------|--------------|
| | FR - A - 1 491 852 (TEXAS) <br> * Figure 1; résumé I 1° * <br><br> -- <br><br> FR - A - 1 347 121 (LIGNES TELE-GRAPHIQUES ET TELEPHONIQUES) <br> * Figure 1; résumé a * <br><br> -- | 1 <br><br><br> 1,2,4 |
| A | FR - E - 74 228 (GENERAL MOTORS) <br> * Figure 3; page 2, colonne de droite, alinéa 1 * <br><br> ---- | 1 |

**CLASSEMENT DE LA DEMANDE (Int. Cl. ³)**

H 01 L 23/06
        23/26
H 05 K  5/06
H 03 H  9/10

**DOMAINES TECHNIQUES RECHERCHES (Int. Cl. ³)**

H 01 L 23/04
        23/06
        23/08
        23/26
H 03 H  9/10
H 05 K  5/06

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achevement de la recherche | Examinateur |
|---------------------|-----------------------------------|-------------|
| La Haye | 28-07-1980 | DE RAEVE |

OEB Form 1503.1  06.78